# EUROPEAN PATENT APPLICATION

(11) **EP 4 843 751 A1**
(43) Date of publication of application: **25.11.2026**
(21) Application number: 25305725.1
(22) Date of filing: 20.05.2025
(51) Int. Cl.: B29C 64/112, B29C 64/268, B29C 64/259, B33Y 10/00, B33Y 30/00, H05K 3/12

(54) **MACHINE AND METHOD FOR MANUFACTURING A PRINTED CIRCUIT BOARD BY MULTIMATERIAL ADDITIVE PRINTING**

(71) Applicant: Institut National de Recherche en Informatique et en Automatique, 78150 Rocquencourt (FR)
(72) Inventor: PEROV, Artem, 91300 Massy (RU); PYKHOVA, Inna, 91300 MASSY (RU)
(74) Representative: Vidon Brevets & Stratégie

(57) **Abstract**

The present application relates to a technique for manufacturing a multilayer printed circuit platform, comprising multimaterial multilayer additive printing means taking into account an 3D virtual object modeling the printed circuit platform to be manufactured, the printing means comprising:
- a set of print cartridges (C1, C2) each comprising:
- means for winding/unwinding the donor substrates of the cartridges between a retracted position and an extended position;
- an optical system (20) equipped with transfer and sintering laser emitting means;
- a control unit (50) configured to successively select a cartridge, trigger displacement of the selected cartridge's donor substrate from the retracted to the extended position, activate the laser transfer source, trigger the movement of the donor substrate from the extended to the retracted position and activate the sintering laser source to structure the donor material on the surface to be coated to form at least one portion of layer.

## Description

### Technical area

The invention falls within the field of additive manufacturing technologies. More particularly, the invention relates to a laser-induced material layering technology applied to 3D printing. The invention has many applications, including printed circuit production.

### Technological background

In the remainder of this document, particular attention is paid to describing the problems encountered in the field of PCB manufacturing. The invention is of course not limited to this particular application context but is of interest to all additive manufacturing technology.

Many technologies are made possible by the ability to pattern a wide variety of materials for specific purposes. Examples of patterning techniques that can be used to deposit materials in desired patterns include - without being exhaustive - inkjet printing, screen printing and laser-induced transfer (LIT).

Laser-induced forward transfer (LIFT) is a well-established technique initially developed for selective deposition of a material onto substrate. LIFT technique involves using a laser to transfer material from a donor substrate to a receiving substrate in a controlled manner. While LIFT has been widely utilized in various applications, such as microelectronics, optics, and biotechnology, but its application in the fabrication of printed circuits has been limited. Existing LIFT technologies have primarily focused on depositing material for creating micro-scale patterns or thin layer, rather than directly printing complex, multi-layered printed circuits. Existing LIFT techniques are slow, complex to implement and generally not very flexible in term of the ability to deliver multi-material, coating thickness and of the diversity of 3D designs that can be created on the print support.

Inkjet printing is another additive manufacturing technique that has been explored for printed circuit fabrication. Existing Inkjet printing techniques involves depositing conductive inks onto a substrate to create electrical traces and circuits. While inkjet printing offers some advantages in terms of flexibility and ease of use, it also has significant limitations. Electrically conductive inks used in inkjet printing often suffer from lower conductivity compared to traditional copper traces, which can result in reduced performance for high-frequency and high-power applications. Additionally, inkjet printing may struggle with producing multi-layered printed circuits with the required precision and mechanical stability for micro-electronics industry.

There is therefore a need to propose a technique for manufacturing 3D free-shape printed circuits based on a more robust multi-layered structure with the possibility of integrating a greater variety of materials and a greater variety of printed circuit features.

### Summary of the invention

The present invention provides a solution to overcome the drawbacks of the prior art.

According to a first aspect, the present technique relates to a machine for manufacturing a printed circuit platform, comprising multilayer additive printing means taking into account an 3D virtual object modeling the printed circuit platform to be manufactured, said additive printing means comprising:
- a plurality of print cartridges comprising:
   ∘ a flexible substrate film adapted to be wound around a storage reel, said film being intended to be coated with a donor material,
   ∘ means for applying the donor material to said film to form a donor substrate;
- means for winding/unwinding the donor substrates of said cartridges between a retracted position in which the donor substrate is wound into the print cartridge and an extended position in which the donor substrate extended facing a surface to be coated;
- an optical system equipped with transfer and sintering laser emitting means;
- a control unit configured to successively:
   ∘ select from said print cartridges a cartridge for which the donor material is to be transferred to the surface to be coated,
   ∘ trigger displacement of the selected cartridge's donor substrate from the retracted to the extended position,
   ∘ activate said laser emitting means to emit a transfer laser beam,
   ∘ trigger the movement of the donor substrate from the extended to the retracted position, and
   o activate said laser emitting means to emit sintering laser beam to structure said donor material on the surface to be coated, to form at least one portion of layer, said control unit being configured to successively select at least two different cartridges to print at least two different donor materials.

The present technique relies on a hybrid method combining Laser-induced forward transfer (LIFT) and sintering techniques to produce, using multimaterial additive manufacturing (i.e. 3D printing technology), a three-dimensional printed circuit integrating various elements to be integrated into volume. This new approach allows integrating different elements, capable of performing various functions, by 3D printing using localized transfer of one or more materials. It makes it possible to print a 3D printed circuit, integrating elements performing one or more functions, these elements being arranged and printed in three dimensions.

During the printing of the printed circuit, one or more materials are printed layer by layer, such as dielectric material, electrically conductive material, semi-conductor material, ceramic material, resistive material, depending on the functions to be performed. This method allows manufacturing a more robust multi-layered structure with the possibility of integrating a greater variety of materials, especially materials with higher conductivity (high viscosity silver nano particles-based pastes, bulk copper foil, etc.).

The term 'printed circuit platform' as used here according to the present invention refers to an assembly of elements integrated in volume and belonging to the group comprising: structural support elements, conductive elements (metal conductors designed to provide electrical connections between components), elements performing one or more passive electronic functions (e.g., resistive function, capacitive function, inductive function, etc.) and elements performing one or more mechanical and/or thermal functions (e.g., heat sinks, mechanical connections, etc.). A 'printed circuit platform' according to a particular embodiment of the invention refers to an assembly consists of an insulated structural support, electronic components and metal conductors (designed to provide electrical connections between electronic components) arranged on the support's surface, commonly known as printed circuit board (PCB).

According to a particularly interesting feature, the machine comprises means for leveling surface of the donor substrate with respect to said surface to be coated, configured to cause, by surface stress, the surface of the donor substrate to move substantially parallel to, and at a predefined transfer distance from, said surface to be coated. Such leveling means ensures a controlled transfer of various materials on the surface to be coated.

According to a particular implementation, said print cartridges each comprise a constant spring force device cooperating with the storage reel and shaped to maintain a uniform load during winding or unwinding of the cartridge's donor substrate. This allows efficient winding and unwinding of the donor substrate of the selected cartridge.

According to a particular implementation, wherein the constant force spring device comprises first and second coils rotatably connected to first and second toothed pulleys and a leaf spring connecting the first and second coils, the storage reel being mounted on a support shaft rotatably linked to a third toothed pulley on which a first belt is mounted, the first belt being in engagement with the first toothed pulley, the second toothed pulley being in engagement with a second belt itself in engagement with a fourth pulley rotatably linked with a leveling shaft. This allows synchronized movement under tension of the support coil and the constant force spring device.

According to a particular implementation, the print cartridges each comprise a fifth pulley linked in rotation with a reference shaft, the fifth pulley being separated from the fourth pulley by a predefined leveling distance and shaped to flex the donor substrate from the storage reel towards an outlet of said cartridge. The donor material is thus spread evenly across the substrate film in a controlled, thin and uniform layer.

According to a particular implementation, the predefined leveling distance is between 5 and 200 µm.

More particularly, the applying means are configured to enable deposition of the donor material onto the film from the storage reel and form the donor substrate prior to being flexed by the fifth pulley, as the donor substrate is moved from the retracted position to the deployed position.

According to a particular implementation, the print cartridges each comprise a pair of magnetic tape storage reels configured to feed the substrate film with a magnetic tape along each of its edges as the film is wound around the film storage reel, each magnetic tape having a magnetic face and a metal face for magnetically adhering to said magnetic face as the film is wound around the film storage reel. Like a rolling pin, these allows, by sliding roller, to spread the donor material evenly

According to a particular implementation, the means for winding/unwinding the donor substrates comprise a gripper configured to grip one of the donor substrates of said cartridges, the gripper being mounted for translational movement along guide elements to move the donor substrate from the retracted position to the deployed position, and vice versa. This ensures a compact and easy winding of the donor substrate around the support reel.

According to a variant of implementation, the machine comprises at least one pair of first and second print cartridges arranged on either side of an axis of said optical system and sharing the same flexible substrate film intended to be coated alternately with first and second donor materials respectively, said pair of first and second print cartridges comprising respectively:
- first and second means for applying the first and second donor materials to form first and second donor substrates,
- first and second means for collecting unused donor material,
said pair of first and second print cartridges and said winding/unwinding means being configured so that, as the first donor substrate moves from the retracted position to the deployed position, the second donor substrate moves the deployed position to the retracted position and the first applying means are activated to coat the first donor material on the substrate film while the second collecting means collect the unused donor material from the substrate film, and vice versa.

According to a particular implementation, the machine is provided with a preheating device configured to preheat said surface to be coated. Preheating ensures a good adhesion of the material to the coated surface, avoids shrinkage of the transferred material. Additive manufacturing is therefore even more controlled.

According to another aspect, the present technique relates to a method of manufacturing a printed circuit platform by additive printing on a surface to be coated, said method being implemented by means of a manufacturing machine (100) comprising a plurality of print cartridges and an optical system equipped with transfer and sintering laser emitting means, each cartridge comprising a flexible substrate film intended to be coated with a donor material to form a donor substrate. Said method is such it comprises a step of forming at least one portion of layer itself comprising the following successive steps:
- select, from said print cartridges, a cartridge for which the donor material is to be transferred to the surface to be coated;
- move the donor substrate of the selected cartridge between a retracted position in which the donor substrate is wound into the print cartridge and an extended position in which the donor substrate is extended facing said surface to be coated;
- activate said laser emitting means to irradiate the donor substrate with a transfer laser beam to selectively transfer particles of the donor material from the donor substrate onto the surface to be coated;
- move the donor substrate from the extended position to the retracted position;
- activate said laser emitting means to irradiate the particles transferred onto the surface to be coated with a sintering laser beam to structure at least one layer portion of material of said object;
at least two iterations of the preceding process steps being implemented to deposit at least two different donor materials as a function of the cartridge selected from said print cartridges.

Thus the method according to the invention removes a technological barrier in that it makes it possible to print with materials of different properties using laser sintering technology.

According to a particular implementation, a step of leveling the substrate surface with respect to said surface to be coated, consisting in causing the donor substrate surface to move substantially parallel, and at a predefined transfer distance, from said surface to be coated, by surface stress, said leveling step being carried out once the donor substrate of the selected cartridge is in the extended position and before activating the transfer laser source.

According to a particular implementation, the step of activating the sintering laser source is preceded by a step of preheating said surface to be coated.

According to another aspect, the present technique relates to a computer program product is provided, comprising program code instructions for implementing the aforementioned method in any of its various embodiments when said program is executed on a computer.

According to another aspect, the present technique relates to a non-transitory computer-readable storage medium is provided, storing the aforementioned computer program product.

### List of figures

Further features and advantages of the invention will become apparent from the following description, given by way of indicative and non-limiting example, and from the appended drawings, in which:
**Figures 1A-1B** and **2A-2B** show, from perspective views, a manufacturing machine according to a particular embodiment of the invention, **Fig. 1A-1B** depicting the machine before starting operation, **Fig. 2A-2B** depicting the machine during operation;
**Figures 3A-3B** are front and side views illustrating the principle of print cartridge selection according to the invention;
**Figures 4A-4B** are front and side views illustrating the principle of donor substrate surface leveling according to the invention;
**Figure 4C** shows an enlarged view of a portion donor substrate during leveling according to the invention;
**Figures 5A to 5C** show the structure of a print cartridge according to a particular embodiment of the invention (**Fig. 5A** being a perspective view, **Fig. 5B** being a top view and **Fig. 5C** being an across-section view along section C-C);
**Figure 5D** shows an enlarged view of means for shaping the donor substrate implementing in the print cartridge of **Figures 5A to 5C****;**
**Figures 6A to 6C** show the internal structure of the print cartridge according to the invention (**Fig. 6A** being a perspective view, **Fig. 6B** being a bottom view and **Fig. 6C** being a side view);
**Figure 7** presents, in the form of a flowchart, a particular embodiment of the method according to the invention;
**Figure 8** is a block diagram of representative of a control unit implemented in the machine according a particular embodiment of the invention;
**Figure 9** shows additive printing means according to a variant of the invention;
**Figure 10** shows additive printing means according to another variant of the invention.

### Detailed description of the invention

In the figures herein, identical elements are designated by the same numerical reference. Furthermore, the elements are not necessarily to scale, the emphasis being on illustrating the principle of the invention.

The general principle of the invention relies on a hybrid method combining Laser-induced forward transfer (LIFT) and sintering techniques to produce, using multimaterial additive manufacturing (i.e. 3D printing technology), a three-dimensional printed circuit platform integrating a set of elements to be integrated into volume.

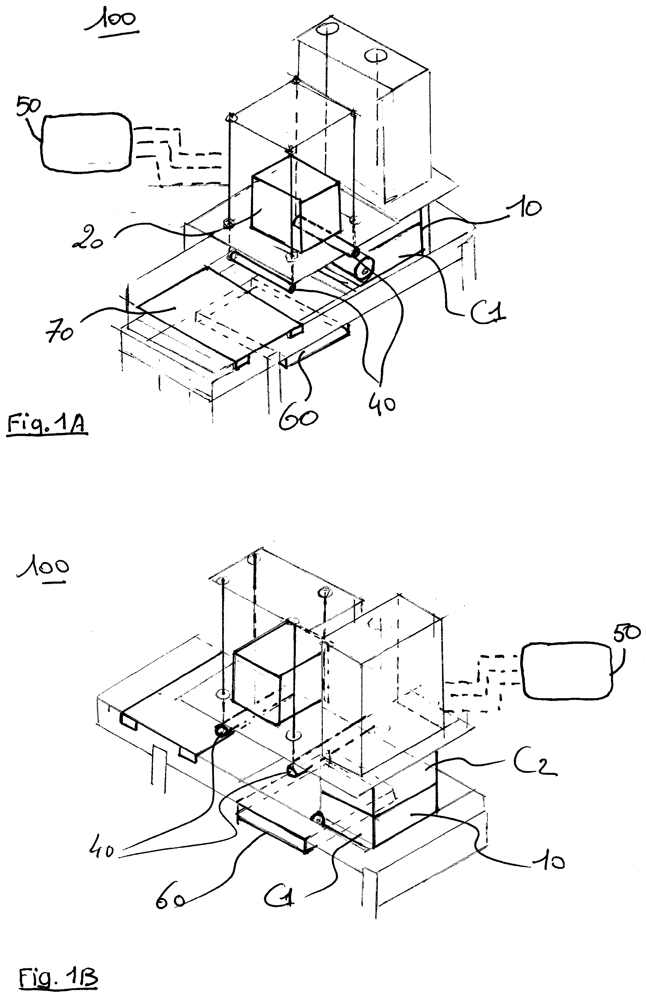

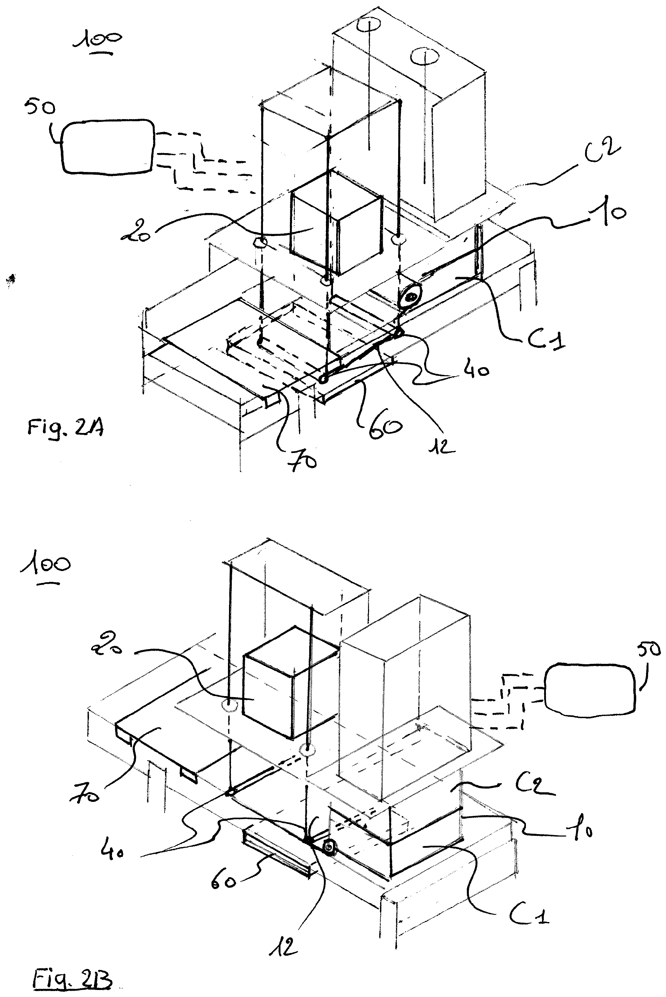

In relation with **Fig. 1A-1B** and **Fig. 2A-2B****,** we now present a machine 100 of manufacturing a multilayer printed circuit board (PCB) according to a particular embodiment of the invention.

This is a programmable machine that automatically performs repetitive tasks at high speed and with precision to produce, by additive printing, a three-dimensional printed circuit from a digital file. This file contains a description of a 3D virtual object modeling the three-dimensional printed circuit board to be manufactured, with all the elements to be integrated in volume: support element, conductive elements, elements performing functions. For example, the shape of the support structure, as well as the positioning of the different materials for each layer (ceramic material, conductive material, dielectric material, magnetic material, etc.) are stored in a first computer file. This first file is then transformed into a second file to generate 2D virtual lamellae (increasing longitudinal "slices" of the structure) for the 3D printing machine.

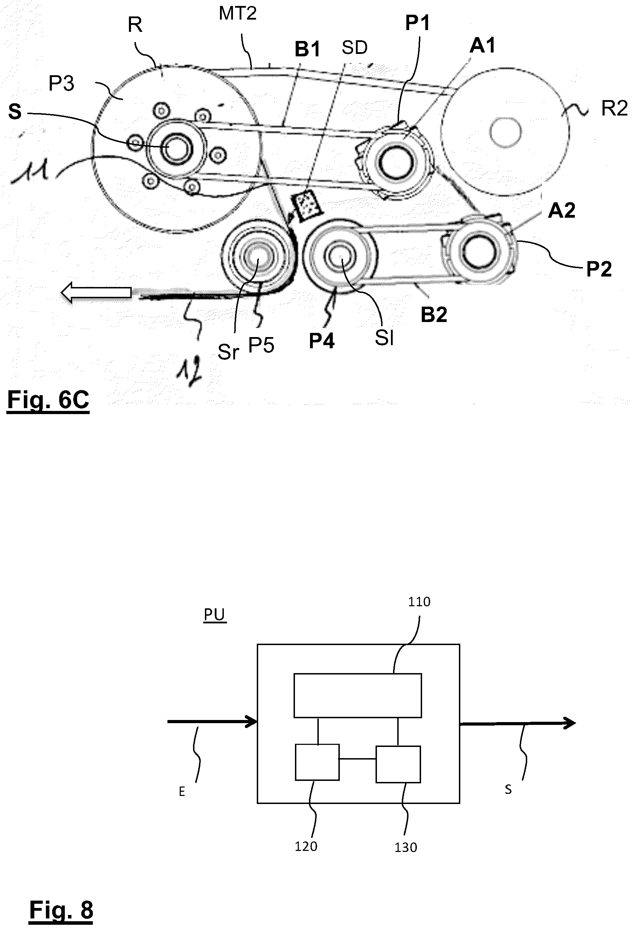

The machine 100 comprises a set of print cartridges 10, an optical system 20, means 30 for winding/unwinding donor substrates, means 40 for leveling donor substrates, a control unit 50, print support 60 and a preheating device 70. The machine 100 may comprise HMI interface which is the dashboard that allows the user to communicate with the machine, giving it instructions and responding to requests for instructions from the microprocessor. Print support 60 is mounted mobile in translation along Z1 axis. Optical system 20 is mounted mobile in translation along X-Y-Z axes. Set of print cartridges 10 is mounted mobile in translation along Z2 axis. Preheating device 70 is mounted mobile in translation along X3 axis. All of elements are mounted on a frame inside of which are installed different driving equipments, in particular drive motors for the moving parts and electronic components that make up the hardware unit controlling the machine. This control unit is electrically connected to the set of cartridges, laser sources, winding/unwinding and leveling means, for the purpose of controlling these elements. The operating principle of this control unit is detailed below in relation to **Fig. 8****.**

### Optical system 20

Optical System 20 is equipped with a transfer laser source, a sintering laser source and beam formation means (not shown) configured to focus and/or shape the laser transfer or sintering beam in the desired area. Such beam formation means comprise a galvanometer scanner head cooperating with an optical lens assembly, like a F-theta lens, to form a transfer beam or a sintering beam depending on which source is activated. This scanner head is configured to adjust the position of the laser beam focus relative to the print support along X, Y, Z spatial directions.

The transfer laser source is a pulsed laser source able to produce a transfer laser beam in the form of picosecond and femtosecond pulses of wavelength that provide maximum absorption rate for printing material. The use of a pulsed source reduces unwanted effects associated with non-linear absorption phenomena in material, thereby minimizing collateral heating. However, to reduce costs, a continuous or nanosecond pulse laser can be used without departing from the scope of the invention, provided that the laser irradiation parameters (power, wavelength, etc.) allow transfer of donor materials. For instance, a laser source emitting in a wavelength comprised within the "green" spectral band (typically 532 nm or 515 nm) can be used for high absorption metal material like copper, silver or nickel. Laser source operating in other spectral bands, like "IR" spectral band (typically 1064 nm, 1070 nm) or "UV" spectral band (typically 355 nm, 405 nm) may be also suitable depending on the trade-off between cost and performance. In order to better absorb local energy from the laser and produce air bubble, a sacrificial layer can be optionally provided between the substrate film and the donor material. This further prevents sensitive printing material from heating during transfer.

The sintering laser source is a pulsed or continuous laser source able to produce a laser sintering beam. For instance, a CO2 laser source operating with a wavelength of 10.6 µm allows a sufficiently efficient localized heating of the irradiated area to bring the material to the sintering temperature. Alternatively, a melting laser source can be used instead of a sintering laser source. Sintering combines materials by heat and pressure, without melting involved, while melting combines particles by heating them till they liquify and combine as one material.

According to an implementation variant, the transfer laser source and the sintering laser source consist of a single laser performing both functions, only the laser parameters that need to be adjusted to achieve the desired optical operating mode (transferring or sintering). An additional CW CO2 laser or diode laser can be used as a material preheater to align temperature gradient in printing material.

### Set of print cartridges 10

The set of print cartridges are intended to supply for donor substrates. Together with the optical system, it forms the printhead of the machine 100. In this exemplary embodiment, the machine 100 comprises two print cartridges C1-C2 intended to supply two different donor substrates and mounted mobile in translation along Z2 axis. The set of print cartridges is mounted motorized on four shafts and cooperates with vertical displacement means to allow displacement and alignment of the selected cartridge with the winding and unwinding means.

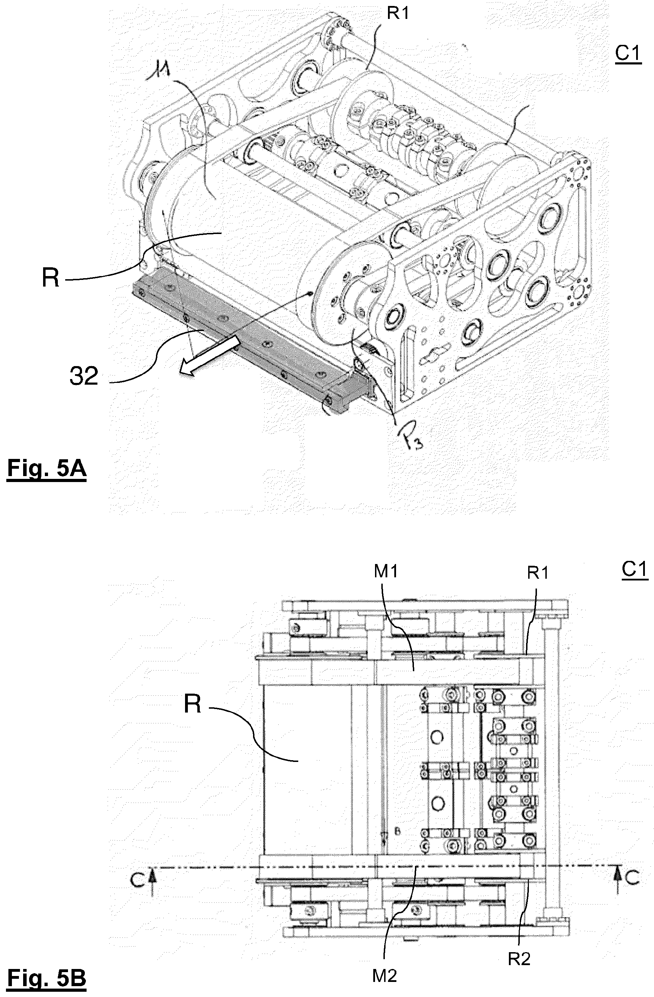

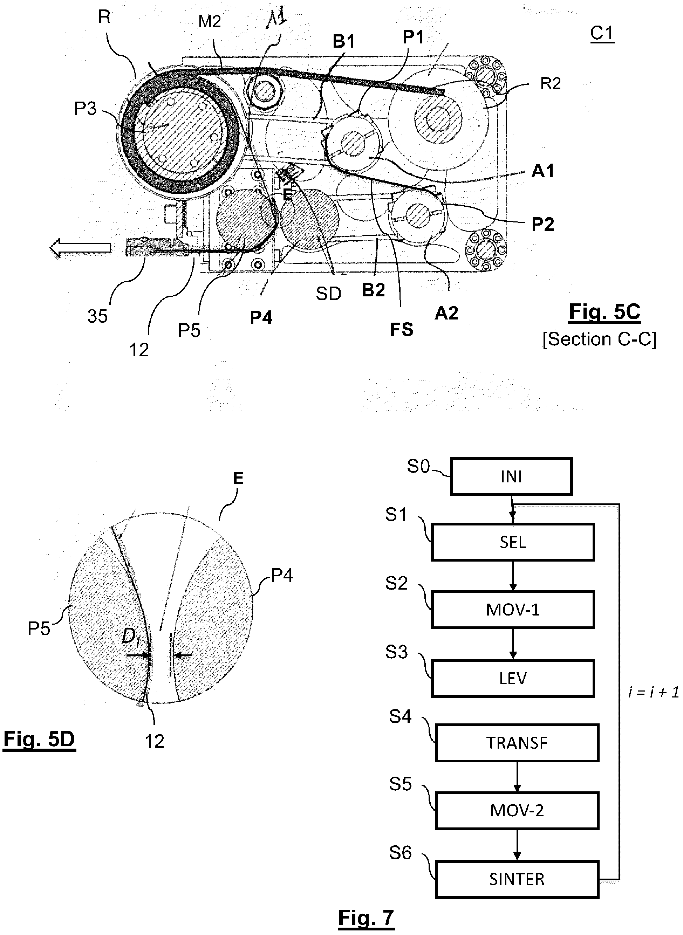

A print cartridge according to the invention comprises a flexible substrate film 11 adapted to be wound around a storage reel, the film being intended to be coated with a donor material. Each cartridge further comprises means for supplying and applying the donor material to the film to form the donor substrate 12. The cartridge comprises a constant spring force device cooperating with the storage reel and configured to maintain a uniform load during winding or unwinding of the cartridge's donor substrate (this principle is described in more details below in relation with **Fig. 5A-5D**).

The flexible substrate film is made from a material optically transparent to wavelength of the transfer laser source and must be flexible enough to be wound around a storage reel, for example: a ceramic glass, an organic glass, a polymer (such as Polyethylene terphthalate (PET), Polyimide (PI), Polyethylene naphthalate (PEN)), to mention just these. The donor material is made from a material that is optically transferable and optically sinterable, such as: dielectric material, electrically conductive material, semi-conductor material, ceramic material, resistive material, depending on the functions to be performed. The donor substrate is so a substrate film on which is coated a donor material.

### Winding/unwinding means 30

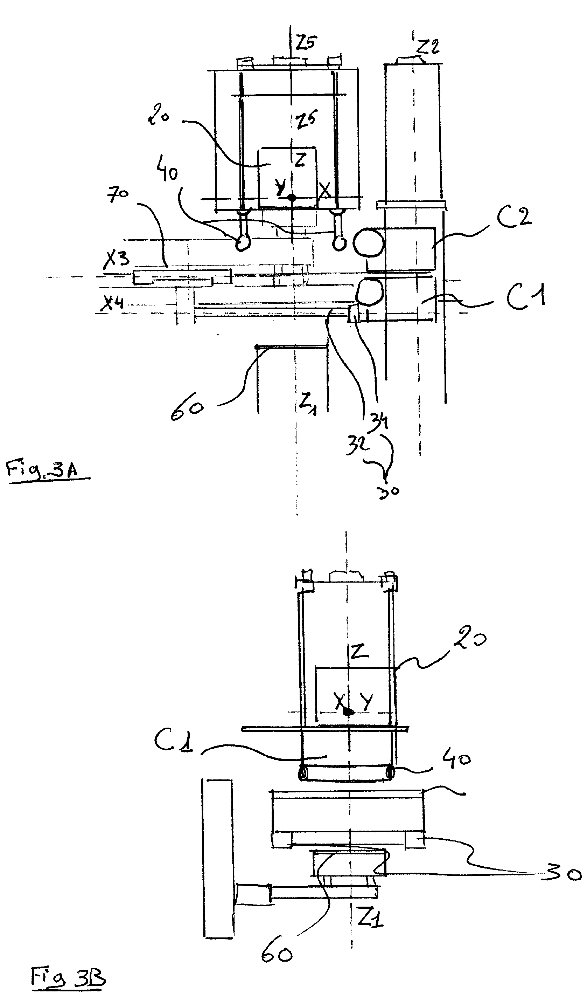

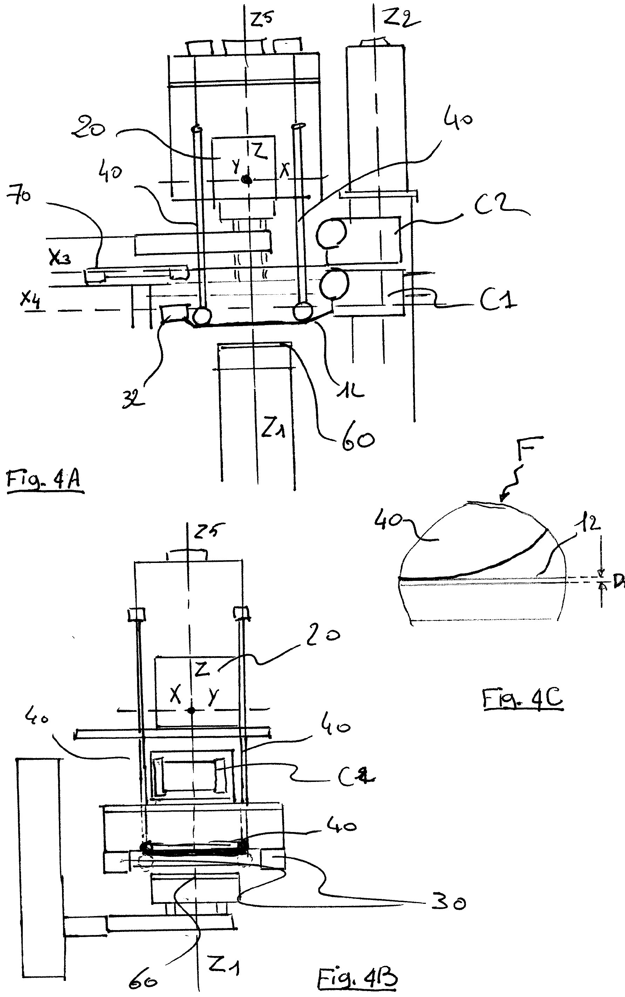

As shown on **Fig. 3A** and **4A****,** winding/unwinding means comprise a gripper 32 mounted mobile in translation along X4 axis. The gripper is mounted motorized on guide elements 34 and cooperates with horizontal mechanical displacement means. **Fig. 5A** shows in more detail the structure of such gripper member 32. Its main function is to seize and pull out donor substrate from the selected cartridge, and vice versa.

More particularly, those means are configured to winding/unwinding the donor substrates of cartridges between a retracted position in which the donor substrate is wound into the print cartridge and an extended position in which the donor substrate extended facing the surface to be coated.

### Leveling means 40

Leveling means comprises a pair of parallel rollers arranged opposite and on both sides of the surface to be coated so as to level surface of the donor substrate, when the donor substrate is in the extended position, with respect to the surface to be coated by causing, by surface stress, the surface of the donor substrate to move substantially parallel to, and at a predefined transfer distance from, the surface to be coated. The transfer distance depends mainly on laser irradiation parameters (wavelength, focal length, ...) and the nature of donor material to be irradiated. Leveling means are mounted mobile translation along X5 axis thanks to mechanical displacement means with which they are mechanically coupled. Z5 axis is confounded with Z and Z1 axes.

### Print support 60

Print support is a mechanically motorized plate cooperating with displacement means for displacing the surface to be coated relative to the laser beam (transfer beam or sintering beam). More particularly, displacement means allow the positioning and the displacement of the print support - and so the surface to be coated along Z1 axes (vertical direction) relative to the laser beam focus. - in the three directions of space along X1, Y1, Z1 axes relative to the laser beam focus. The expression "surface to be coated" means the print support surface if no layer has been yet coated or the surface of the precedingly layer coated by the machine.

Alternatively or additionally, the mechanically motorized plate is configured to position according to three spatial directions relative to the laser beam focus.

### Preheating device 70

Preheating device comprises a motorized plate equipped with a plurality of heating elements intended to preheat the donor material transferred on the surface being coated. For example, heating elements are infrared heating lamps evenly distributed across the bottom of the motorized plate. The plate is mounted mobile in translation along X3 axis between a rest position in which heating elements are outside the drop-off zone and a work position in which heating elements are placed above the surface being coated. The use of a preheating device enables evaporation of solvents from the material transferred and other paste components. It can also prevent premature or uneven cooling. Preheating ensures a good adhesion of the material to the coated surface, avoids shrinkage of the material, thereby helping to maintain shape of the manufactured object.

### Principle of machine operation

The following section describes, in relation to **Fig. 7****,** the operation of the machine 100 step by step for manufacturing a 3D printed circuit according to the invention. These steps are carried out by the control unit 50 mentioned above.

### Step S0 ("INI")

Upon reception of the digital file containing a description of the 3D virtual object modeling the multilayer printed circuit to be manufactured, the control unit 50 initiates the manufacturing process of the printed circuit. This file describes *n* of virtual 2D slices whose superposition forms the 3D virtual object. For example, the shape of the structure of 3D printed circuit, as well as the positioning of the different materials for each layer (ceramic material, conductive material, dielectric material, magnetic material, etc.) are stored in this file.

Before moving on to the actual manufacturing step, a preliminary calibration step may be carried out to compensate for any play between parts and ensure that they are perfectly positioned in relation to each other.

The 3D printed circuit is manufactured by stacking a plurality of layers, each layer corresponding to one of n virtual 2D slices described in the file. Each layer is produced by depositing one or more of the materials discussed above, by instructing the different elements of the machine. For each layer, the material or materials are selected according to the part of the elements (to be integrated into the volume and enabling the desired functions to be performed) found in that layer.

For instance, the 3D virtual object modeling a printed circuit integrating into the volume a set of elements performing a set of functions. The set of elements comprises for example: a support element, conductive elements (e.g., connection tracks, ground plane, offset areas, etc.), elements performing one or more passive electronic functions (e.g., resistive function, capacitive function, inductive function, etc.) and elements performing one or more mechanical and/or thermal functions (e.g., heat sinks, mechanical connections, etc.). The support and all these elements are manufactured using additive manufacturing (3D printing) with different materials: one or more support materials for the support part of each layer and one or more other materials for the non-support part or parts of each layer.

The control unit 50 uses index i as *i^{th}* layer to be deposited on the surface to be coated, i being an integer such as 0 > *i* > *n.*

### Step S1 ("SEL")

The control unit 50 adjusts the height of the print support 60 along Z1 axis according to the index i of layer to be deposited, as well as the scanner head's position relative to the print support 60.

The control unit 50 then selects, from print cartridges C1-C2, the cartridge for which the donor material is to be transferred to the surface to be coated according to the description of the corresponding virtual 2D slice. Cartridge C1, which contains a dielectric donor material for example, is then positioned so that the cartridge output is at the level of X4 axis of winding/unwinding means. At this step, the donor substrate of cartridge C1 is in a retracted position in which the donor substrate 12 is wound into the print cartridge.

### Step S2 ("MOV-1")

The control unit 50 triggers displacement of the selected cartridge's donor substrate from the retracted position to the extended position by activating winding/unwinding means 30. More particularly, the gripper 32 is displaced along to X4 axis to seize the free end of the donor substrate 12 at cartridge C1 and move the seized donor substrate from the retracted position (**Fig. 3A**) to the extended position (**Fig. 4A**) in which the donor substrate 12 is extended facing the surface to be coated.

### Step S3 ("LEV")

Once the donor substrate 12 is extended facing the surface to be coated, the control unit 50 triggers means 40 for leveling surface of the donor substrate 12 extended facing the surface to be coated with respect to said surface to be coated (**Fig. 4B**) according to Z5 axis. The pair of parallel rollers applies a surface stress on the surface of the donor substrate so that it moves substantially parallel to, and at a predefined transfer distance from, the surface to be coated (**Fig. 4C**). The transfer distance, labelled *D_{T}* in the figure, is comprised between 10 and 100 µm, depending on nature of selected donor material and parameters used for optical system.

### Step S4 ("TRANSF")

Once the surface of donor substrate 12 positioned at transfer distance from the surface to be coated, the control unit 50 triggers the transfer laser source to irradiate the donor substrate so as to selectively transfer particles of the dielectric material from the donor substrate onto the surface to be coated (acting as an acceptor surface). The control unit 50 drives the machine's motors enabling the relative movement of the transfer laser beam in relation to the surface to be coated in X-Z directions as a function of the pattern to be printed described in the file for the concerned virtual 2D slice.

### Step S5 ("MOV-2")

Once the transfer step is complete, the control unit 50 triggers inverse displacement of the selected cartridge's donor substrate from the extended position to the retracted position by activating winding/unwinding means 30. More particularly, the gripper 32 is displaced along to X4 axis from the extended position to the retracted position, then releases the free end of the donor substrate 12. Before triggering the displacement of donor substrate, the control unit 50 triggers the withdrawal of the pair of rollers applying the surface stress to allow winding of the donor substrate in the cartridge C1.

### Step S6 ("SINTER")

The control unit 50 triggers the sintering laser source to irradiate the particles of dielectric material transferred at step S4 and thus structure the part or parts of layer associated with this dielectric material.

In order to better control the cooling process of 3D printed material, the sintering step is preceded by a step of preheating the printing support 60 consisting at positioning the preheating device 70 in its work position so that the heating elements placed above the surface being coated increase the temperature of said surface to a solvent evaporation temperature approximately between 100 and 400 °C during few minutes (e.g. from 30 to 280 seconds) depending on material type. Once the preheating is complete, the preheating device 70 returns to its rest position and the laser irradiation sintering phase can be triggered.

After sintering, the control unit 50 checks if another material is to be coated for that *i^{th}* layer.

If verified, the control unit 50 reiterates the steps S1 to S6 by selecting another cartridge among the set of print cartridges of the machine 100, according to the description of the corresponding virtual 2D slice (e.g. the cartridge C2 illustrated in the Figures). The control unit 50 reiterates the steps S1 to S6 for a same layer as long as another material are to be deposited.

If not verified, the control unit 50 considers that the process has been done for the *i^{th}* layer and it can process the next layer of the printed circuit to be manufactured. Index *i* is then set to *i + 1* (*i = i + 1*) and the control unit 50 reiterates steps S1 to S6 described above by considering the description of the next 2D virtual slice of the file obtained at step S0. This entire process is therefore repeated layer by layer up to the index *i* is equal to *n,* meaning that the multilayer printed circuit manufacturing is complete.

### Principle of cartridge operation

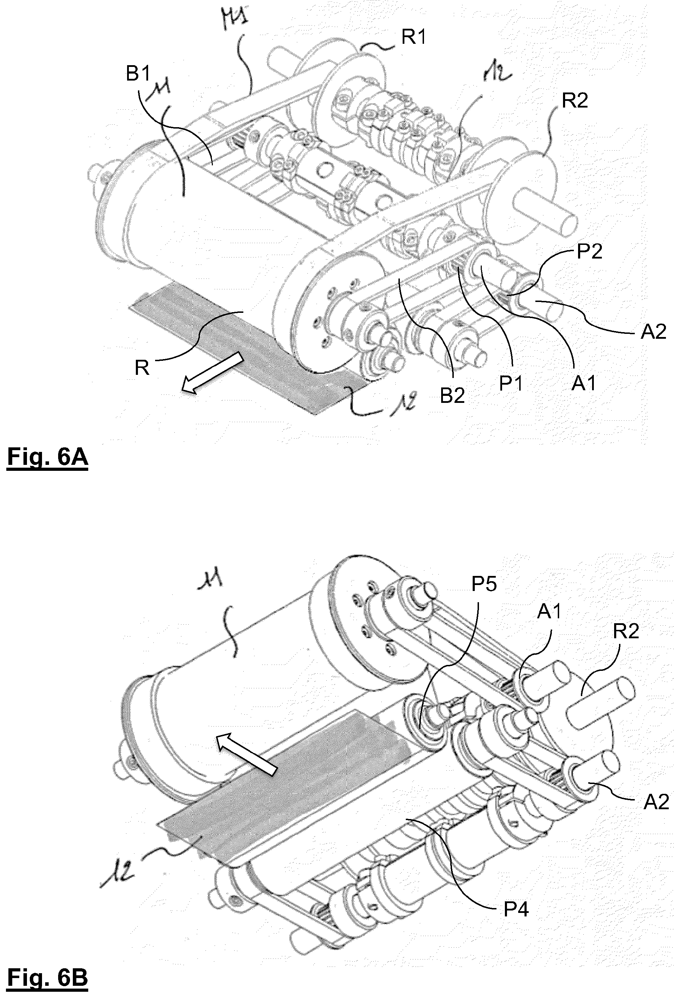

The following is an example of the structure and operation of a print cartridge according to the invention, in relation with **Fig. 5A to 5D** and **Fig.6A to 6C****.**

Print cartridge C1 comprises a constant spring force device cooperating with the storage reel R and configured to maintain a uniform load during winding or unwinding of the cartridge's donor substrate 12. The constant force spring device comprises first and second coils A1-A2 rotatably connected to first and second toothed pulleys P1-P2 and a leaf spring FS connecting the first and second coils A1-A2, the storage coil R being mounted on a support shaft S rotatably linked to a third toothed pulley P3 on which a first belt B1 is mounted, the first belt B1 being in engagement with the first toothed pulley P1, the second toothed pulley P2 being in engagement with a second belt B2 itself in engagement with a fourth pulley P4 rotatably linked with a leveling shaft Sl. This allows to apply a constant tension during substrate winding and unwinding regardless of the substrate length unwound.

Print cartridge C1 further comprises a fifth pulley P5 linked in rotation with a reference shaft Sr, the fifth pulley P5 being separated from the fourth pulley P4 by a predefined leveling distance and shaped to flex the donor substrate 12 from the storage reel R towards the cartridge outlet. The leveling distance, labelled *Dₗ* in the **Fig. 5D**, is comprised between 5 and 200 µm. It allows the thickness of the donor material (coated on the substrate film) subjected to the transfer laser beam to be set. The reference shaft is therefore rotationally linked to the support coil R via the flexible substrate. Using synchronization belts allows that all the devices are thus synchronized: synchronized movement under tension of the support coil and the leveling shaft, and by extension of the reference shaft.

When the donor substrate 12 is set in motion by actioning winding/unwinding means, the substrate film 11 is supplied in donor material via a supplying device SD arranged on the path of substrate film 11 between the pulley P3 and pulleys P4-P5 (leveling and reference shafts). The donor material that enters the gap between the leveling and reference pulleys P4-P5 during unwinding is spread evenly across the substrate film in a thin and uniform layer. The set elements comprising pulleys P4-P5 and supplying device SD form the means for applying the donor material to the substrate film to form a donor substrate according to the invention.

In order to prevent contact between the surface that has been exposed to the transfer laser beam and the unexposed surface during winding of the donor substrate around the storage coil R, a pair of magnetic tape storage reels R1-R2 configured to feed the substrate film with a magnetic tape MT1-MT2 along each of its edges as the film 11 is wound around the film storage coil R, each magnetic tape having a magnetic face and a metal face (e.g. iron or another magnetic material) for magnetically adhering to said magnetic face as the film is wound around the film storage coil R. This allows for an efficient and compact winding of the substrate film around the support coil R.

**Fig. 8** shows, in a simplified and schematic manner, the structure of a processing unit PU implementing the method according to the invention (for example, n iterations of steps S0 to S6 described above in connection with **Fig. 7**).

This processing device PU comprises a random-access memory 130 (e.g., a RAM), a CPU unit 110, equipped for example with a processor or microprocessor, and controlled by a computer program stored in a read-only memory 120 (e.g., a ROM or a hard disk). Upon initialization, the code instructions of the computer program are, for example, loaded into the random-access memory 130 before being executed by the processor of the CPU unit 110. Such a computer program allows the execution of step S0 then several iterations of steps S1 to S6 described above. The processing unit PU receives input instructions, namely a digital file containing a description of a 3D virtual object modeling the multilayer printed circuit to be manufactured (represented by the arrow E). The processor of the CPU unit then executes the method based on the input instructions E and outputs the corresponding control/driving commands (represented by the arrows S) to the different constituent elements of the machine's print means, according to the instructions of program 120.

**Fig. 8** illustrates only one of several possible ways of carrying out the various steps detailed above. The processing method according to the invention can be carried out indifferently:
- on a reprogrammable computing machine (a PC, a DSP processor or a microcontroller) executing a program comprising a sequence of instructions; or
- on a dedicated computing machine (e.g., a set of logic gates such as an FPGA or ASIC, or any other hardware module).

Where the invention is implemented on a reprogrammable computing machine, the corresponding program (i.e., the sequence of instructions) may or may not be stored on a removable storage medium (such as a floppy disk, CD-ROM, or DVD-ROM), which storage medium is partially or totally readable by a computer or processor.

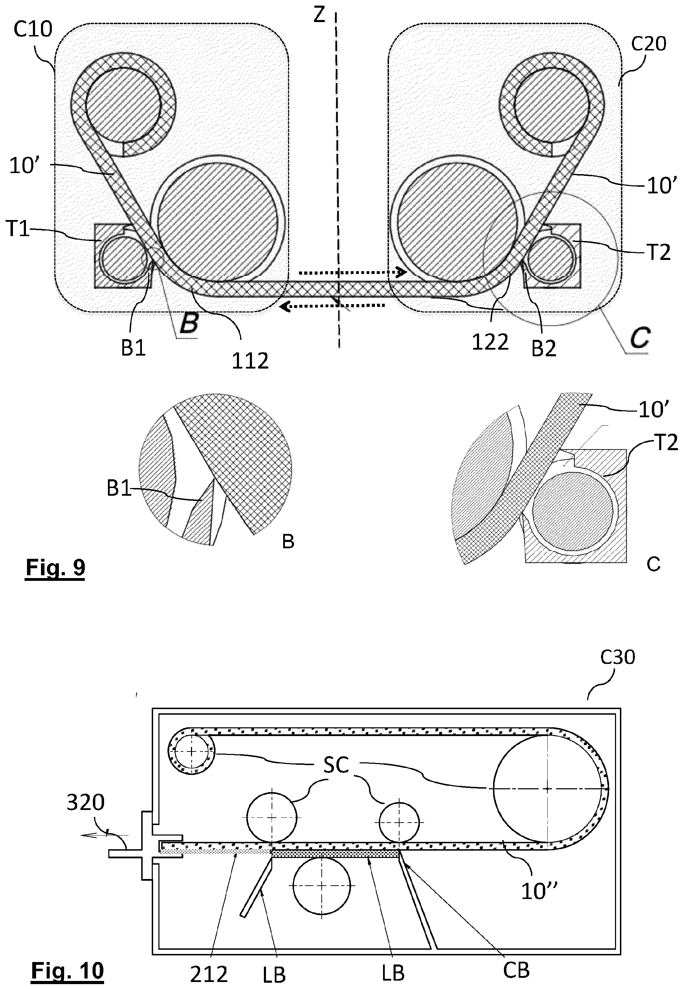

We now present, in relation with **Fig. 9** and **Fig. 10****,** two variants of implementation of additive printing means according to the invention.

According to the variant shown in **Fig. 9****,** the additive printing means comprises one pair of and print cartridges C10 and C20 arranged symmetrically on either side of Z axis of the optical system. These additive printing means have the distinctive feature of sharing the same flexible substrate film 10' and containing different donor materials. Each print cartridge comprises their own winding/unwinding means cooperating to allow horizontal back-and-forth movements of the donor substrate (represented by the two opposing arrows). The substrate film 10' is intended to be coated alternately with a first donor material (e.g. dielectric material) and a second donor material (e.g. electrically conductive material): print cartridge C10 comprises means T1 for applying the dielectric material on the inferior surface of the substrate film 10' to form a donor substrate 112 as the substrate film 10' is unwinding from left to right, while print cartridge C20 comprises means T2 for applying the conductive material on the inferior surface of the substrate film 10' to form a donor substrate 122 as the substrate film 10' is winding from right to left. Applying means can comprise a pump system, donor material tank and controller. Each print cartridge relies on the use of a coil-based system as shown in the figure. Each print cartridge also comprises a cleaning blade and a unused material tank conformed to form means of collecting unused donor material: print cartridge C10 comprises a cleaning blade B1 shaped and oriented to remove unused donor material from the substrate' inferior surface as the substrate film 10' is moved from right to left, while print cartridge C20 comprises a cleaning blade B2 shaped and oriented to remove unused donor material from the substrate' inferior surface as the substrate film 10' is moved from left to right. During operation, print cartridges C10-C20 and said winding/unwinding means are activated so that, upon selection of cartridge C10 for which the donor material is to be transferred to the surface to be coated, as the donor substrate 112 moves from the retracted position to the deployed position, the second donor substrate 122 moves from the deployed position to the retracted position and the applying means T1 are activated to coat the dielectric material on the substrate film 10' while the cleaning blade B2 passively collect the unused donor material from the substrate film, and vice versa.

This variant of the printhead enables that the donor substrate is not stretched over the entire printed surface but instead has a strip of substrate with a material applied to it, the transfer of which is carried out by sweeping the laser beam along one coordinate. Printing along the second coordinate is carried out by mechanical movement of the print support. In this way, the film in the cartridge continuously moves back and forth, ensuring that fresh material is always present in the printing area for transfer onto the print substrate. In that variant, there is no need in specific leveling system like in the embodiment described above (leveling system 40). The gap between the substrate film and the print platform is controlled by the design tolerances. For each type of material, a different print head is used, which allows the device to realize a multi-material printing system.

According to the variant shown in **Fig. 10****,** the additive printing means relies on the use of printed cartridge C30 which is based on a method equivalent to the screen-printing process where the donor substrate is stretched over the entire printing surface area. Such a printed cartridge comprises:
- a system of coils arranged for moving, once the cartridge selected, the donor substrate 132 from the retracted to the extended position and for moving, after transfer the donor substrate 132, from the extended position to the retracted position;
- means for applying (not shown) the donor material DM to the film to form a donor substrate 10";
- a leveling blade LB configured to level the layer of the donor material DM applied onto the film 10" at the desired thickness as the donor substrate 212 moves from the retracted position to the deployed position;
- a cleaning blade CB configured to collect the unused donor material from the substrate film as the donor substrate 212 moves from the deployed position to the retracted position.

Printed cartridge C30 cooperates with winding/unwinding means in accordance with the principle discussed above in relation to the first embodiment, which comprise a gripper 320 mounted for translational movement and configured to grip the donor substrate 212 of the printed cartridge C30 and displace it from the retracted position to the deployed position, and vice versa.

Different realizations of the printhead of the machine are therefore possible, but the operating principle of the manufacturing method described above remains the same and mainly comprises several iterations of the following steps: select one of the print cartridges for which the donor material is to be transferred to the surface to be coated, trigger displacement of the selected cartridge's donor substrate from the retracted to the extended position, activate the laser emitting means to emit a transfer laser beam, trigger the movement of the donor substrate from the extended to the retracted position, and activate the laser emitting means to emit sintering laser beam to structure the donor material on the surface to be coated to form at least one portion of layer.

## Claims

1. Machine for manufacturing a printed circuit platform, comprising multilayer additive printing means taking into account an 3D virtual object modeling the printed circuit platform to be manufactured, said additive printing means comprising:
- a plurality of print cartridges (C1, C2) comprising:
∘ a flexible substrate film adapted to be wound around a storage reel, said film being intended to be coated with a donor material,
∘ means for applying the donor material to said film to form a donor substrate;
- means (30) for winding/unwinding the donor substrates of said cartridges between a retracted position in which the donor substrate is wound into the print cartridge and an extended position in which the donor substrate extended facing a surface to be coated;
- an optical system (20) equipped with transfer and sintering laser emitting means;
- a control unit (50) configured to successively:
∘ select from said print cartridges a cartridge for which the donor material is to be transferred to the surface to be coated,
∘ trigger displacement of the selected cartridge's donor substrate from the retracted to the extended position,
∘ activate said laser emitting means to emit a transfer laser beam,
∘ trigger the movement of the donor substrate from the extended to the retracted position, and
∘ activate said laser emitting means to emit sintering laser beam to structure said donor material on the surface to be coated to form at least one portion of layer, said control unit being configured to successively select at least two different cartridges to print at least two different donor materials.

2. Machine according to claim 1, comprising means (40) for leveling surface of the donor substrate (12) with respect to said surface to be coated, configured to cause, by surface stress, the surface of the donor substrate to move substantially parallel to, and at a predefined transfer distance from, said surface to be coated.

3. Machine according to any one of claims 1 and 2, wherein said print cartridges each comprise a constant spring force device cooperating with the storage reel and shaped to maintain a uniform load during winding or unwinding of the cartridge's donor substrate.

4. Machine according to claim 3, wherein the constant force spring device comprises first and second coils rotatably connected to first and second toothed pulleys (P1-P2) and a leaf spring (FS) connecting the first and second coils, the storage reel being mounted on a support shaft rotatably linked to a third toothed pulley (P3) on which a first belt (C1) is mounted, the first belt being in engagement with the first toothed pulley, the second toothed pulley being in engagement with a second belt (C2) itself in engagement with a fourth pulley (P4) rotatably linked with a leveling shaft.

5. Machine according to claim 4, wherein the print cartridges each comprise a fifth pulley (P5) linked in rotation with a reference shaft, the fifth pulley being separated from the fourth pulley by a predefined leveling distance and shaped to flex the donor substrate from the storage reel towards an outlet of said cartridge.

6. Machine according to claim 5, wherein the applying means are configured to enable deposition of the donor material onto the film from the storage reel and form the donor substrate prior to being flexed by the fifth pulley, as the donor substrate is moved from the retracted position to the deployed position.

7. Machine according to any one of claims 1 to 6, wherein the print cartridges each comprise a pair of magnetic tape storage reels (R1-R2) configured to feed the substrate film with a magnetic tape (M1-M2) along each of its edges as the film is wound around the film storage reel, each magnetic tape having a magnetic face and a metal face for magnetically adhering to said magnetic face as the film is wound around the film storage reel.

8. Machine according to any one of claims 1 to 7, wherein the means (30) for winding/unwinding the donor substrates comprise a gripper (32) configured to grip one of the donor substrates of said cartridges, the gripper being mounted for translational movement along guide elements to move the donor substrate from the retracted position to the deployed position, and vice versa.

9. Machine according to any one of claims 1 and 2, comprising at least one pair of first and second print cartridges (C10, C20) arranged on either side of an axis of said optical system and sharing the same flexible substrate film (10) intended to be coated alternately with first and second donor materials respectively, said pair of first and second print cartridges comprising respectively:
- first and second means (T1-T2) for applying the first and second donor materials to form first and second donor substrates,
- first and second means (B1-B2) for collecting unused donor material,
said pair of first and second print cartridges and said winding/unwinding means being configured so that, as the first donor substrate moves from the retracted position to the deployed position, the second donor substrate moves from the deployed position to the retracted position and the first applying means are activated to coat the first donor material on the substrate film while the second collecting means collect the unused donor material from the substrate film, and vice versa.

10. Machine according to any one of claims 1 to 9, which is provided with a preheating device (70) configured to preheat said surface to be coated.

11. Method of manufacturing a printed circuit platform by additive printing on a surface to be coated, said method being implemented by means of a manufacturing machine (100) comprising a plurality of print cartridges and an optical system equipped with transfer and sintering laser emitting means, each cartridge comprising a flexible substrate film intended to be coated with a donor material to form a donor substrate, said method being **characterized in that** it comprises a step of forming at least one portion of layer itself comprising the following successive steps:
- select (S1), from said print cartridges, a cartridge for which the donor material is to be transferred to the surface to be coated;
- move (S2) the donor substrate of the selected cartridge between a retracted position in which the donor substrate is wound into the print cartridge and an extended position in which the donor substrate is extended facing said surface to be coated;
- activate (S4) said laser emitting means to irradiate the donor substrate with a transfer laser beam to selectively transfer particles of the donor material from the donor substrate onto the surface to be coated;
- move (S5) the donor substrate from the extended position to the retracted position;
- activate (S6) said laser emitting means to irradiate the particles transferred onto the surface to be coated with a sintering laser beam to structure at least one layer portion of material of said object;
at least two iterations of the preceding process steps being implemented to deposit at least two different donor materials as a function of the cartridge selected from said print cartridges.

12. Method according to claim 11, comprising a step of leveling (S3) the substrate surface with respect to said surface to be coated, consisting in causing the donor substrate surface to move substantially parallel, and at a predefined transfer distance, from said surface to be coated, by surface stress, said leveling step being carried out once the donor substrate of the selected cartridge is in the extended position and before activating the transfer laser source.

13. Method according to any one of claims 11 and 12, in which the step of activating the sintering laser source is preceded by a step of preheating said surface to be coated.

14. Computer program product, comprising program code instructions for implementing the method according to any one of claims 11 to 13, when said program is executed on a computer.

15. Computer-readable non-transitory storage medium storing a computer program product according to claim 14.

## Amended claims

### Amended claims in accordance with Rule 137(2) EPC.

1. Machine for manufacturing a printed circuit platform, comprising multilayer additive printing means taking into account an 3D virtual object modeling the printed circuit platform to be manufactured, said additive printing means comprising:
- a plurality of print cartridges (C1, C2) comprising:
∘ a flexible substrate film adapted to be wound around a storage reel, said film being intended to be coated with a donor material,
∘ means for applying the donor material to said film to form a donor substrate;
- means (30) for winding/unwinding the donor substrates of said cartridges between a retracted position in which the donor substrate is wound into the print cartridge and an extended position in which the donor substrate extended facing a surface to be coated;
- an optical system (20) equipped with transfer and sintering laser emitting means;
- a control unit (50) configured to successively:
∘ select from said print cartridges a cartridge for which the donor material is to be transferred to the surface to be coated,
∘ trigger displacement of the selected cartridge's donor substrate from the retracted to the extended position,
∘ activate said laser emitting means to emit a transfer laser beam,
∘ trigger the movement of the donor substrate from the extended to the retracted position, and
o activate said laser emitting means to emit sintering laser beam to structure said
donor material on the surface to be coated to form at least one portion of layer, said control unit being configured to successively select at least two different cartridges to print at least two different donor materials.

2. Machine according to claim 1, comprising means (40) for leveling surface of the donor substrate (12) with respect to said surface to be coated, configured to cause, by surface stress, the surface of the donor substrate to move substantially parallel to, and at a predefined transfer distance from, said surface to be coated.

3. Machine according to any one of claims 1 and 2, wherein said print cartridges each comprise a constant spring force device cooperating with the storage reel and shaped to maintain a uniform load during winding or unwinding of the cartridge's donor substrate.

4. Machine according to claim 3, wherein the constant force spring device comprises first and second coils rotatably connected to first and second toothed pulleys (P1-P2) and a leaf spring (FS) connecting the first and second coils, the storage reel being mounted on a support shaft rotatably linked to a third toothed pulley (P3) on which a first belt (C1) is mounted, the first belt being in engagement with the first toothed pulley, the second toothed pulley being in engagement with a second belt (C2) itself in engagement with a fourth pulley (P4) rotatably linked with a leveling shaft.

5. Machine according to claim 4, wherein the print cartridges each comprise a fifth pulley (P5) linked in rotation with a reference shaft, the fifth pulley being separated from the fourth pulley by a predefined leveling distance and shaped to flex the donor substrate from the storage reel towards an outlet of said cartridge.

6. Machine according to claim 5, wherein the applying means are configured to enable deposition of the donor material onto the film from the storage reel and form the donor substrate prior to being flexed by the fifth pulley, as the donor substrate is moved from the retracted position to the deployed position.

7. Machine according to any one of claims 1 to 6, wherein the print cartridges each comprise a pair of magnetic tape storage reels (R1-R2) configured to feed the substrate film with a magnetic tape (M1-M2) along each of its edges as the film is wound around the film storage reel, each magnetic tape having a magnetic face and a metal face for magnetically adhering to said magnetic face as the film is wound around the film storage reel.

8. Machine according to any one of claims 1 to 7, wherein the means (30) for winding/unwinding the donor substrates comprise a gripper (32) configured to grip one of the donor substrates of said cartridges, the gripper being mounted for translational movement along guide elements to move the donor substrate from the retracted position to the deployed position, and vice versa.

9. Machine according to any one of claims 1 and 2, comprising at least one pair of first and second print cartridges (C10, C20) arranged on either side of an axis of said optical system and sharing the same flexible substrate film (10) intended to be coated alternately with first and second donor materials respectively, said pair of first and second print cartridges comprising respectively:
- first and second means (T1-T2) for applying the first and second donor materials to form first and second donor substrates,
- first and second means (B1-B2) for collecting unused donor material,
said pair of first and second print cartridges and said winding/unwinding means being configured so that, as the first donor substrate moves from the retracted position to the deployed position, the second donor substrate moves from the deployed position to the retracted position and the first applying means are activated to coat the first donor material on the substrate film while the second collecting means collect the unused donor material from the substrate film, and vice versa.

10. Machine according to any one of claims 1 to 9, which is provided with a preheating device (70) configured to preheat said surface to be coated.

11. Method of manufacturing a printed circuit platform by additive printing on a surface to be coated, said method being implemented by means of a manufacturing machine (100) comprising a plurality of print cartridges and an optical system equipped with transfer and sintering laser emitting means, each cartridge comprising a flexible substrate film intended to be coated with a donor material to form a donor substrate, said method being **characterized in that** it comprises a step of forming at least one portion of layer itself comprising the following successive steps:
- select (S1), from said print cartridges, a cartridge for which the donor material is to be transferred to the surface to be coated;
- move (S2) the donor substrate of the selected cartridge between a retracted position in which the donor substrate is wound into the print cartridge and an extended position in which the donor substrate is extended facing said surface to be coated;
- activate (S4) said laser emitting means to irradiate the donor substrate with a transfer laser beam to selectively transfer particles of the donor material from the donor substrate onto the surface to be coated;
- move (S5) the donor substrate from the extended position to the retracted position;
- activate (S6) said laser emitting means to irradiate the particles transferred onto the surface to be coated with a sintering laser beam to structure at least one layer portion of material of said object;
at least two iterations of the preceding process steps being implemented to deposit at least two different donor materials as a function of the cartridge selected from said print cartridges.

12. Method according to claim 11, comprising a step of leveling (S3) the substrate surface with respect to said surface to be coated, consisting in causing the donor substrate surface to move substantially parallel, and at a predefined transfer distance, from said surface to be coated, by surface stress, said leveling step being carried out once the donor substrate of the selected cartridge is in the extended position and before activating the transfer laser source.

13. Method according to any one of claims 11 and 12, in which the step of activating the sintering laser source is preceded by a step of preheating said surface to be coated.

14. Computer program product comprising program code instructions configured to control a manufacturing machine (100) for manufacturing a printed circuit platform, said machine comprising a plurality of print cartridges (C1, C2), means (30) for winding/unwinding a donor substrate of the cartridges, and an optical system (20) equipped with transfer and sintering laser emitting means,
wherein the program code instructions, when executed on a computer, are configured to cause the machine to successively:
- select (S1), from said print cartridges, a cartridge for which a donor material is to be transferred to a surface to be coated;
- control the winding/unwinding means (30) to move (S2) the donor substrate of the selected cartridge from a retracted position to an extended position in which the donor substrate is facing said surface to be coated;
- control the optical system (20) to activate (S4) the transfer laser emitting means to irradiate the donor substrate to selectively transfer particles of the donor material onto the surface to be coated;
- control the winding/unwinding means (30) to move (S5) the donor substrate from the extended position to the retracted position; and
- control the optical system (20) to activate (S6) the sintering laser emitting means to irradiate the particles transferred onto the surface to be coated to structure at least one layer portion;
wherein the instructions are configured to cause the machine to perform at least two iterations of the preceding steps to deposit at least two different donor materials.

15. Computer-readable non-transitory storage medium storing a computer program product according to claim 14.
